(19) Europäisches Patentamt
European Patent Office
Office européen des brevets

(11) **EP 3 711 162 B1**

(12) **EUROPÄISCHE PATENTSCHRIFT**

(45) Veröffentlichungstag und Bekanntmachung des Hinweises auf die Patenterteilung:
**16.08.2023   Patentblatt 2023/33**

(21) Anmeldenummer: **18833900.6**

(22) Anmeldetag: **28.12.2018**

(51) Internationale Patentklassifikation (IPC):
**H03K 17/082** (2006.01)      **H03K 17/14** (2006.01)

(52) Gemeinsame Patentklassifikation (CPC):
**H03K 17/0822; H03K 17/145**

(86) Internationale Anmeldenummer:
**PCT/EP2018/097090**

(87) Internationale Veröffentlichungsnummer:
**WO 2019/149437 (08.08.2019 Gazette 2019/32)**

(54) **SCHUTZ EINES IN EINEM SCHALTBETRIEB BETRIEBENEN FELDEFFEKTTRANSISTORS VOR EINEM ÜBERLASTSTROM**

PROTECTION OF A FIELD EFFECT TRANSISTOR IN SWITCHING OPERATION AGAINST OVERLOAD

PROTECTION D'UN TRANSISTOR À EFFET DE CHAMP FONCTIONNANT DANS LE MODE DE COMMUTATION CONTRE UN COURANT DE SURCHARGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.01.2018   EP 18154076**

(43) Veröffentlichungstag der Anmeldung:
**23.09.2020   Patentblatt 2020/39**

(73) Patentinhaber: **Siemens Aktiengesellschaft**
**80333 München (DE)**

(72) Erfinder:
• **MÄRZ, Andreas**
**91227 Leinburg (DE)**
• **BAKRAN, Mark-Matthias**
**91052 Erlangen (DE)**

(74) Vertreter: **Siemens Patent Attorneys**
**Postfach 22 16 34**
**80506 München (DE)**

(56) Entgegenhaltungen:
**US-A- 4 920 447          US-A- 5 394 287**
**US-A- 5 898 557          US-A1- 2017 163 255**
**US-A1- 2017 331 369**

**Beschreibung**

Die Erfindung betrifft ein Verfahren zum Schutz eines in einem Schaltbetrieb betriebenen Feldeffekttransistors vor einem Überlaststrom in einem eingeschaltetem Schaltzustand, bei dem eine elektrische Drain-Source-Spannung zwischen einem Drain-Anschluss und einem Source-Anschluss des Feldeffekttransistors erfasst wird, die Drain-Source-Spannung mit einem vorgegebenen Spannungsvergleichswert verglichen wird, und der Feldeffekttransistor bei einer größeren Drain-Source-Spannung als dem Spannungsvergleichswert in einen ausgeschalteten Schaltzustand geschaltet wird, wobei zum Zwecke einer Temperaturkompensation des Schutzes eine Temperatur des Feldeffekttransistors erfasst wird, und der Spannungsvergleichswert abhängig von der Temperatur eingestellt wird. Die Erfindung betrifft ferner eine Schutzeinrichtung für einen in einem Schaltbetrieb betriebenen Feldeffekttransistor zum Schutz vor einem Überlaststrom in einem eingeschalteten Schaltzustand, zu welchem Zweck die Schutzeinrichtung ausgebildet ist, eine elektrische Drain-Source-Spannung zwischen einem Drain-Anschluss und einem Source-Anschluss des Feldeffekttransistors zu erfassen, die Drain-Source-Spannung mit einem vorgegebenen Spannungsvergleichswert zu vergleichen, und den Feldeffekttransistor bei einer größeren Drain-Source-Spannung als dem Spannungsvergleichswert in einen ausgeschalteten Schaltzustand zu schalten, und zum Zwecke einer Temperaturkompensation des Schutzes eine Temperatur des Feldeffekttransistors zu erfassen, und den Spannungsvergleichswert abhängig von der Temperatur einzustellen. Schließlich betrifft die Erfindung auch einen Feldeffekttransistor.

Feldeffekttransistoren werden in Bereichen der Elektronik an vielen Stellen eingesetzt, um unterschiedlichste elektrische Funktionen realisieren zu können. Feldeffekttransistoren finden Einsatz in elektrischen Hardwareschaltungen, die zur Realisierung vorgegebener Funktionen dienen. Derartige Hardwareschaltungen können im Bereich der Datenverarbeitung z.B. digitale Speicher, Rechnereinrichtungen, Logikschaltungen und/oder dergleichen sein. Mittlerweile sind auch leistungsfähige Feldeffekttransistoren verfügbar, die z.B. in der elektrischen Energietechnik Einsatz finden, beispielsweise bei einem statischen Umrichter, in einem elektronischen Netzteil und/oder dergleichen. Feldeffekttransistoren können je nach Einsatzgebiet einen unterschiedlichen Aufbau aufweisen.

Ein Feldeffekttransistor weist in der Regel wenigstens drei Elektroden als Anschlüsse auf, nämlich einen Source-Anschluss, einen Drain-Anschluss sowie einen Gate-Anschluss. Durch eine geeignete Steuerspannung zwischen dem Gate-Anschluss und dem Source-Anschluss kann ein Stromfluss zwischen dem Drain-Anschluss und dem Source-Anschluss eingestellt werden.

Feldeffekttransistoren können dem Grunde nach als Sperrschichtfeldeffekttransistoren oder auch als Isolierschichtfeldeffekttransistoren (Metal Oxide Semiconductor Field Effect Transistor, MOSFET) oder dergleichen ausgebildet sein. Insbesondere Isolierschichtfeldeffekttransistoren können darüber hinaus eine vierte Elektrode als Anschluss aufweisen, einen sogenannten Bulk-Anschluss, der jedoch häufig nicht als separater Anschluss des Feldeffekttransistors ausgeführt ist, sondern stattdessen oftmals innerhalb des Feldeffekttransistors an den Source-Anschluss angeschlossen sein kann.

Feldeffekttransistoren werden häufig in einem Schaltbetrieb betrieben. Der Schaltbetrieb des Feldeffekttransistors bedeutet, dass in einem eingeschalteten Schaltzustand zwischen den die Schaltstrecke bildenden Anschlüssen des Feldeffekttransistors, hier der Drain-Anschluss und der Source-Anschluss, ein sehr geringer elektrischer Widerstand bzw. Durchlasswiderstand bereitgestellt wird, so dass ein hoher Stromfluss bei kleiner Durchlassspannung bzw. Drain-Source-Spannung möglich ist. Im ausgeschalteten Schaltzustand ist dagegen die Schaltstrecke des Feldeffekttransistors hochohmig, d.h., sie stellt einen hohen elektrischen Widerstand bereit, so dass auch bei hoher, an der Schaltstrecke anliegender Spannung bzw. Drain-Source-Spannung im Wesentlichen kein oder nur ein sehr geringer, insbesondere vernachlässigbarer Stromfluss vorliegt. Hiervon unterscheidet sich ein Linearbetrieb, bei dem auch Zwischenzustände nahezu kontinuierlich eingenommen werden können. Sowohl in der Digitaltechnik als auch im Bereich der Energietechnik wird der Feldeffekttransistor jedoch in der Regel im Schaltbetrieb betrieben. Feldeffekttransistoren nach Art von MOSFETs finden insbesondere im Bereich der Energietechnik bei Energiewandlern wie Umrichtern, Wechselrichtern, Gleichspannungswandlern und/oder dergleichen Einsalz.

Für die Verbesserung einer Leistungsdichte bei Energiewandlern, beispielsweise bei Wechselrichtern, Gleichspannungswandlern oder dergleichen stellt der Einsatz von Feldeffekttransistoren, insbesondere nach Art von unipolaren Wide-Bandgap-Leistungshalbleitern im Vergleich zu im Stand der Technik üblichen bipolaren Transistoren aufgrund der möglichen geringeren Schaltverluste ein großes Anwendungspotential dar.

Während des bestimmungsgemäßen Betriebs eines Energiewandlers kann es aufgrund einer Störung eines Bauelements des Umrichters oder einer angeschlossenen Komponente zu einem Fehlerfall kommen.

Einer dieser Fehlerfälle kann ein Kurzschluss sein. Dabei können unterschiedliche Kurzschlussszenarien bestimmt werden.

Bei einem ersten Fall eines Kurzschlusses kann der Feldeffekttransistor zunächst in einem ausgeschalteten Schaltzustand sein und dann bei einem bestehenden Kurzschluss eingeschaltet werden.

Bei einem zweiten Fall eines Kurzschlusses kann der Feldeffekttransistor im eingeschalteten Schaltzustand bereits einen bestimmungsgemäßen Strom mittels seiner Schaltstrecke führen, wenn ein Kurzschluss aufgrund eines weiteren Transistors, der mit dem Feldeffekttransistor zusammenwirkt, beispielsweise in einer Halbbrückenschaltung oder dergleichen, auftritt. Der Transistor kann beispielsweise ebenfalls ein Feldeffekttransistor sein.

Bei einem dritten Fall eines Kurzschlusses kann der Feldeffekttransistor im eingeschalteten Schaltzustand bereits einen bestimmungsgemäßen Strom mittels seiner Schaltstrecke führen, wenn ein Kurzschluss aufgrund eines Kurzschlusses einer Diode und/oder dergleichen auftritt.

Der erste, der zweite und der dritte Kurzschlussfall zeichnen sich dadurch aus, dass der Strom durch die Schaltstrecke sehr schnell ansteigt, wobei er im Extremfall lediglich durch parasitäre Induktivitäten begrenzt sein kann, bis der Feldeffekttransistor entsättigt wird und dadurch der weitere Anstieg des Stromes begrenzt wird.

Darüber hinaus kann noch der Überstromfall unterschieden werden, bei dem ein Drainstrom bzw. ein Sourcestrom des Feldeffekttransistors langsamer ansteigt.

Im eingeschalteten Schaltzustand wird der Feldeffekttransistor in der Regel so weit wie möglich aufgesteuert, so dass eine Restspannung zwischen dem Drain-Anschluss und dem Source-Anschluss möglichst gering wird, damit auch Durchlassverluste im eingeschalteten Schaltzustand möglichst gering sind.

Insgesamt ist es gewünscht, die unterschiedlichen Fälle für Kurzschlüsse bzw. auch den Überstromfall möglichst temperaturabhängig zu erfassen, sodass der jeweilige Kurzschlussfall bzw. Überstromfall von einem bestimmungsgemäßen Betrieb im eingeschalteten Schaltzustand gut unterschieden werden kann, das heißt, von einem fehlerlosen Betriebsfall.

Um die vorgenannten Fehlerfälle ermitteln zu können, ist es im Stand der Technik bereits bekannt, die Entsättigung der Schaltstrecke zu erfassen. Diese wird üblicherweise bei auch bipolaren Transistoren verwendet. Zu diesem Zweck wird die elektrische Spannung an der Schaltstrecke ab einer vorgegebenen, fest eingestellten Ausblendzeit, in der die Kurzschlussdetektion deaktiviert ist, erfasst. Die erfasste Spannung wird mit einer Vergleichsspannung verglichen, die auf einen fest vorgegebenen Wert eingestellt ist, z.B. 15 V oder dergleichen. Ist die erfasste Spannung größer als die Vergleichsspannung und ist die seit dem Einschalten des Transistors in dem eingeschalteten Schaltzustand abgelaufene Zeit größer als die Ausblendzeit, wird dies als Kurzschluss erkannt. Die Ausblendzeit ist in diesem Fall auf einen festen, vorgegebenen Wert eingestellt.

Da Feldeffekttransistoren, insbesondere MOSFETs, als unipolare Halbleiterbauelemente eine Schaltstrecke aufweisen, die im eingeschalteten Schaltzustand ein widerstandsähnliches Verhalten aufweist, kann der Spannungsvergleichswert zum Erkennen eines Kurzschlusses kleiner gewählt werden, z.B. 7 V oder dergleichen. Vorzugsweise beträgt der Spannungsvergleichswert beispielsweise etwa der dreifachen Drain-Source-Spannung im eingeschalteten Schaltzustand, die an der Schaltstrecke abfällt, wenn sie mit einem Bemessungsstrom beaufschlagt wird.

Die Drain-Source-Spannung im eingeschalteten Schaltzustand, auch Durchlassspannung genannt, ist von der Temperatur des Feldeffekttransistors abhängig, insbesondere von einer Sperrschichttemperatur. Aufgrund der teilweise hohen Temperaturabhängigkeit der Durchlassspannung, insbesondere bei planaren und trench SiC MOSFETs kann die Temperaturabhängigkeit dazu führen, dass die Durchlassspannung abhängig von der Temperatur sich nahezu um einen Faktor 2 ändern kann. Dies kann sich auf die Erkennung des Kurzschlusses auswirken.

Um eine diesbezügliche Problematik zu reduzieren, ist es im Stand der Technik üblich, den Spannungsvergleichswert abhängig von der Temperatur einzustellen. Zu diesem Zweck kann vorgesehen sein, die Temperatur des Feldeffekttransistors mittels eines Temperatursensors, z.B. einem temperaturabhängigen Widerstand oder dergleichen, zu erfassen. In diesem Zusammenhang offenbart die US 2017/0331369 A1 einen Energiewandler sowie ein Verfahren zu dessen Steuerung. Die US 2017/0163255 A1 offenbart eine Vorrichtung mit integriertem Schutzverlauf sowie ein Verfahren hierfür.

Auch wenn sich die bekannte Vorgehensweise bewährt hat, so besteht dennoch Verbesserungsbedarf. So hat sich gezeigt, dass der Spannungsvergleichswert, weil er konstant ist, selbst wenn er temperaturabhängig eingestellt wird, doch so hoch gewählt werden muss, dass ein zuverlässiger Schutz des Feldeffekttransistors nicht in jeder Betriebslage sicher gewährleistet werden kann. Zumindest muss damit gerechnet werden, dass bei einem Überlastereignis wie den oben beschriebenen Überlaststromereignissen eine vorzeitige Alterung des Feldeffekttransistors auftreten kann, und es dann in der Folge zu unerwünschten Folgeerscheinungen kommen kann.

Der Erfindung liegt die Aufgabe zugrunde, den Schutz des Feldeffekttransistors gegen Überlaststrom zu verbessern.

Als Lösung werden mit der Erfindung ein Verfahren, eine Schutzeinrichtung sowie ein Feldeffekttransistor gemäß den unabhängigen Ansprüchen vorgeschlagen.

Vorteilhafte Weiterbildungen ergeben sich durch Merkmale der abhängigen Ansprüche.

Bezüglich eines gattungsgemäßen Verfahrens wird insbesondere vorgeschlagen, dass der Spannungsvergleichswert während des eingeschalteten Schaltzustands ergänzend auch von der Zeit abhängt.

Bezüglich einer gattungsgemäßen Schutzeinrichtung wird insbesondere vorgeschlagen, dass die Schutzeinrichtung ferner ausgebildet ist, den Spannungsvergleichswert während des eingeschalteten Schaltzustands ergänzend auch abhängig von der Zeit einzustellen.

Bezüglich eines gattungsgemäßen Feldeffekttransistors wird insbesondere vorgeschlagen, dass dieser eine Schutzeinrichtung gemäß der Erfindung aufweist.

Die Erfindung basiert auf dem Gedanken, dass durch eine geeignete Anpassung des Spannungsvergleichswerts über die Zeit die Schutzfunktion in Bezug auf den Überlaststrom erheblich verbessert werden kann. Dabei berücksichtigt die Anpassung des Spannungsvergleichswerts nicht nur abhängig von der Temperatur sondern auch abhängig von der Zeit spezifische Eigenschaften des Feldeffekttransistors bzw. der Schaltung, an die er angeschlossen sein kann. Der Spannungsvergleichswert ist somit vorzugsweise nicht nur ausschließlich von der Temperatur sondern ergänzend auch zumindest teilweise von der Zeit abhängig. Auch die Temperaturabhängigkeit kann auf bestimmte Bereiche des Zeitabschnitts, in welchem der Feldeffekttransistor im eingeschalteten Schaltzustand ist, begrenzt sein. Dadurch können in hochflexibler Weise die besonderen Eigenschaften, die bei Feldeffekttransistoren jeweils vorliegen können, eingegangen werden.

Besonders vorteilhaft erweist es sich dabei, wenn die Schutzeinrichtung darüber hinaus einstellbar ausgebildet ist, sodass die Schutzwirkung gemäß der Erfindung nahezu individuell eingestellt werden kann. Beispielsweise kann vorgesehen sein, dass die Schutzeinrichtung programmierbar ist und sowohl die Abhängigkeit des Spannungsvergleichswerts von der Temperatur als auch von der Zeit bedarfsgerecht eingestellt werden kann. Es kann vorgesehen sein, dass die Einstellung der Schutzeinrichtung bei ihrer Herstellung oder auch bei einer Erstinbetriebnahme des Feldeffekttransistors in einer elektronischen Schaltung, in der er angeschlossen ist, erfolgt. Darüber hinaus besteht natürlich auch die Möglichkeit, die Schutzeinrichtung so auszugestalten, dass eine Einstellbarkeit auch zu einem späteren Zeitpunkt, beispielsweise im Rahmen einer Wartung oder dergleichen vorgenommen werden kann.

Die Schutzeinrichtung kann durch eine elektronische Hardwareschaltung gebildet sein, die zumindest teilweise auch in einen Halbleiter-Chip, der den Feldeffekttransistor selbst bereitstellt, integriert sein kann. Es kann jedoch auch eine separate Baugruppe vorgesehen sein, die z.B. in ein Gehäuse des Feldeffekttransistors integriert angeordnet und an den Feldeffekttransistor in geeigneter Weise angeschlossen ist.

Die Schutzeinrichtung kann eine Hardwareschaltung umfassen, die die gewünschte bzw. erforderliche Funktionalität bereitstellt. Die Hardwareschaltung kann jedoch auch zumindest teilweise durch eine Rechnereinheit gebildet sein, die mittels eines geeigneten Rechnerprogramms gesteuert wird, um die gewünschte Funktionalität bereitzustellen. Dadurch kann die Schutzeinrichtung auch auf einfache Weise programmierbar ausgebildet sein.

Der Feldeffekttransistor ist vorzugsweise ein MOSFET, insbesondere ein MOSFET des Anreicherungstyps.

Während des eingeschalteten Schaltzustands meint vorliegend, dass in diesem Zeitraum, der den eingeschalteten Schaltzustand kennzeichnet, kein Wechsel des Schaltzustands des Feldeffekttransistors erfolgt. Es können jedoch abwechselnd eingeschaltete und ausgeschaltete Schaltzustände zeitlich aufeinander abfolgen. Es folgen daher vorzugsweise immer zeitlich abwechselnd ein eingeschalteter Schaltzustand und ein ausgeschalteter Schaltzustand unmittelbar aufeinander. Während eines eingeschalteten Schaltzustands meint also insbesondere einen Zeitraum, in dem der Feldeffekttransistor im eingeschalteten Schaltzustand ist, und der zwischen zwei unmittelbar benachbarten Schaltzuständen des ausgeschalteten Schaltzustands ist.

Bezüglich des exponentiellen Änderns des Spannungsreduktionswerts ist darüber hinaus vorgesehen, dass eine Zeitkonstante angepasst an eine Abklingzeitkonstante einer Schwingung der Drain-Source-Spannung gewählt wird. Diese Ausgestaltung kann berücksichtigen, dass mit dem Einnehmen des eingeschalteten Schaltzustands bzw. mit dem Einschalten des Feldeffekttransistors eine Schwingung auftreten kann, die gedämpft ist. Die entsprechende Abklingzeitkonstante dieser gedämpften Schwingung kann bei dem exponentiellen Ändern des Spannungsreduktionswertes entsprechend berücksichtigt werden. Dadurch kann eine nahezu optimale Anpassung der Schutzfunktion gemäß der Erfindung erreicht werden.

Der Spannungsvergleichswert wird zu einem vorgegebenen ersten Zeitpunkt während des eingeschalteten Schaltzustands um einen vorgegebenen Spannungsreduktionswert reduziert. Auch diese Ausgestaltung ermöglicht es, die Zuverlässigkeit der Spannungsdetektion zu verbessern. Dabei kann mit dieser Weiterbildung eine besonders vorteilhafte einfache Realisierung der Reduzierung des Spannungsvergleichswerts abhängig von der Zeit erreicht werden. So kann z.B. für einen Zeitraum vom unmittelbaren Einschalten des Feldeffekttransistors bis zum ersten Zeitpunkt ein erster Spannungsvergleichswert vorgesehen sein, wobei der Spannungsvergleichswert zum ersten Zeitpunkt auf einen kleineren Spannungsvergleichswert gesetzt wird. Dies kann durch den Spannungsreduktionswert erreicht werden. Es können jedoch auch zwei unterschiedliche Spannungsvergleichswerte vorgesehen sein, die lediglich zum ersten Zeitpunkt umgeschaltet werden. Hierdurch kann eine einfache und kostengünstige Realisierung erreicht werden.

Der Spannungsvergleichswert wird abhängig von der Zeit während des eingeschalteten Schaltzustands reduziert. Dadurch kann erreicht werden, dass aufgrund im bestimmungsgemäßen Betrieb auftretenden unerwünschten Effekten, die jedoch keines der vorgenannten Kurzschlussereignisse bilden, fälschlicherweise ein Kurzschlussereignis detektiert wird. So kann hierdurch z.B. erreicht werden, dass Einschwingvorgänge, die bei einem Wechsel von einem ausgeschalteten Schaltzustand in einen eingeschalteten Schaltzustand auftreten können, nicht in unerwünschter Weise zu einer Kurzschlussdetektion führen. Durch das Reduzieren des Spannungsvergleichswerts abhängig von der Zeit kann erreicht werden, dass unmittelbar nach dem Einschalten des Feldeffekttransistors auftretende Einschwingvorgänge nur dann berücksichtigt werden, wenn sie einen erhöhten Stromwert zur Folge haben. Die Zuverlässigkeit der Detektion eines Überlaststromes kann dadurch weiter verbessert werden.

Gemäß einer vorteilhaften Weiterbildung wird vorgeschlagen, dass der erste Zeitpunkt ebenfalls von der Temperatur abhängt. Dadurch kann die Schutzwirkung der Erfindung weiter verbessert werden. So kann vorgesehen sein, dass der erste Zeitpunkt mit zunehmender Temperatur zeitlich früher liegt. Dadurch kann das Zeitfenster für den Spannungsvergleichswert vor dem ersten Zeitpunkt verkleinert werden, um thermische Auswirkungen des Feldeffekttransistors, insbesondere des Halbleiter-Chips, besser berücksichtigen zu können. Bei alternativen Ausführungen, bei denen es sinnvoll sein kann, kann ferner auch vorgesehen sein, dass der erste Zeitpunkt mit zunehmender Temperatur zu einem späteren Zeitpunkt liegt. Natürlich besteht auch die Möglichkeit diese Ausgestaltungen miteinander zu kombinieren und so z.B. einen funktionalen Zusammenhang zwischen der Lage des ersten Zeitpunkts innerhalb des eingeschalteten Schaltzustands abhängig von der Temperatur realisieren zu können. Durch diese Ausgestaltung können unterschiedliche physikalische Effekte des Feldeffekttransistors besser berücksichtigt werden.

Der erste Zeitpunkt liegt mit zunehmender Temperatur vorzugsweise früher. Hierdurch können typische spezifische thermische Eigenschaften von Feldeffekttransistoren gut berücksichtigt werden.

Gemäß einer Weiterbildung wird vorgeschlagen, dass der Spannungsvergleichswert zwischen einem Einschaltzeitpunkt des Feldeffekttransistors und dem ersten Zeitpunkt konstant eingestellt wird. Hierdurch können insbesondere Kurzschlüsse des ersten und des zweiten Falls und gegebenenfalls auch des dritten Falls gut erfasst werden. In der Regel sind derartige Kurzschlüsse besonders kritisch und häufig nur unwesentlich von der Temperatur abhängig. Es ist deshalb in dieser Ausgestaltung nicht unbedingt erforderlich, den Spannungsvergleichswert zwischen dem Einschaltzeitpunkt des Feldeffekttransistors und dem ersten Zeitpunkt auch abhängig von der Temperatur einzustellen. Vielmehr kann es ausreichen, hier einen festen Wert vorzusehen, der von der Temperatur unabhängig eingestellt werden kann.

Darüber hinaus wird vorgeschlagen, dass der Spannungsreduktionswert zu einem zweiten Zeitpunkt, der später als der erste Zeitpunkt während des eingeschalteten Schaltzustands liegt, aktiviert wird. Der Spannungsreduktionswert braucht also in dieser Ausführungsform nicht zugleich mit dem ersten Zeitpunkt aktiviert zu werden. Vielmehr kann ein späterer zweiter Zeitpunkt gewählt werden, um den Spannungsreduktionswert zu aktivieren.

Vorzugsweise ist hierbei der Spannungsreduktionswert von der Temperatur abhängig. Der Spannungsreduktionswert kann vorzugsweise mit zunehmender Temperatur ebenfalls zunehmen. Auch hier kann ein funktionaler Zusammenhang so gewählt sein, dass er an physikalische Eigenschaften des Feldeffekttransistors angepasst ist.

Weiterhin wird vorgeschlagen, dass der Spannungsreduktionswert zu einem dritten Zeitpunkt, der später als der zweite Zeitpunkt während des eingeschalteten Schaltzustands liegt, größer ist. Hierdurch kann eine besonders einfache Realisierung für einen von der Temperatur abhängigen Spannungsreduktionswert realisiert werden. Es ist also möglich, durch Umschalten der Spannungsreduktionswerte zu den jeweiligen Zeitpunkten eine entsprechende Anpassung vorzunehmen. Hierdurch können weitere Eigenschaften des Feldeffekttransistors und/oder der an den Feldeffekttransistor angeschlossenen elektronischen Schaltung berücksichtigt werden.

Besonders vorteilhaft erweist es sich, wenn der Spannungsvergleichswert zwischen dem ersten und dem zweiten Zeitpunkt abhängig von der Zeit kontinuierlich geändert wird. Es kann bei dieser Weiterbildung vorgesehen sein, dass kein Sprung des Spannungsvergleichswerts erfolgt. Vielmehr folgt ein kontinuierlicher Übergang von dem Spannungsvergleichswert vor dem ersten Zeitpunkt und dem Spannungsvergleichswert nach dem zweiten Zeitpunkt. Hierdurch kann eine verbesserte Funktionalität auch hinsichtlich der Schutzfunktion in Bezug auf den Überlaststrom erreicht werden.

Vorzugsweise wird der Spannungsreduktionswert zumindest teilweise linear geändert. Zwischen dem ersten und dem zweiten Zeitpunkt ist also zumindest teilweise ein linearer Übergang zwischen den unterschiedlichen Spannungsvergleichswerten realisiert. Dies kann durch den sich zumindest teilweise linear ändernden Spannungsreduktionswert erreicht werden.

Der Spannungsreduktionswert braucht jedoch nicht linear geändert zu werden. Gemäß einer Weiterbildung kann er zumindest teilweise auch exponentiell geändert werden. Natürlich können diese Ausgestaltungen auch miteinander kombiniert sein, um besonders vorteilhafte und angepasste Funktionalitäten erreichen zu können.

Die für das erfindungsgemäße Verfahren angegebenen Vorteile und Wirkungen gelten gleichermaßen für die erfindungsgemäße Schutzeinrichtung sowie den mit der erfindungsgemäßen Schutzeinrichtung ausgerüsteten Feldeffekttransistor sowie auch umgekehrt. Insofern können für Verfahrensmerkmale auch Vorrichtungsmerkmale formuliert sein und umgekehrt.

Weitere Vorteile und Wirkungen sowie Merkmale ergeben sich durch die im Folgenden anhand der Figuren beschriebenen Ausführungsbeispiele. In den Figuren bezeichnen gleiche Bezugszeichen gleiche Merkmale und Funktionen.

Es zeigen:

FIG 1     in einer schematischen Schaltbildanordnung eine Halbbrückenschaltung mit zwei in Reihe geschalteten MOSFETs als Schaltelementen;

FIG 2     eine schematische Diagrammdarstellung zum Darstellen von Kurzschlussdetektionsschwellen bei einem planaren SiC MOSFET für eine Sperrspannung von 1200 V abhängig von einer Temperatur des MOSFETs bei einer Gate-Source-Spannung von etwa 15 V als Steuerspannung;

FIG 3 eine schematische Diagrammdarstellung wie FIG 2, bei der nunmehr die Gate-Source-Spannung als Steuerspannung etwa 20 V beträgt;

FIG 4 eine schematische Diagrammdarstellung bezüglich eines Einschaltverhaltens eines SiC MOSFET abhängig von einer Temperatur des MOSFET sowie einer ersten Kommutierungsinduktivität;

FIG 5 eine schematische Darstellung wie FIG 4, jedoch nun für eine zweite Kommutierungsinduktivität, die größer ist als die erste Kommutierungsinduktivität;

FIG 6 eine schematische Blockschaltbilddarstellung für eine Schutzeinrichtung gemäß der Erfindung;

FIG 7 eine schematische Schaltbilddarstellung für eine Treiberschaltung für einen MOSFET in der Halbbrückenschaltung gemäß FIG 1 mit einer Schutzeinrichtung gemäß der Erfindung; und

FIG 8 eine schematische Diagrammdarstellung zur Darstellung eines Schutzbereichs, der mit der Schutzeinrichtung der Erfindung erreicht werden kann.

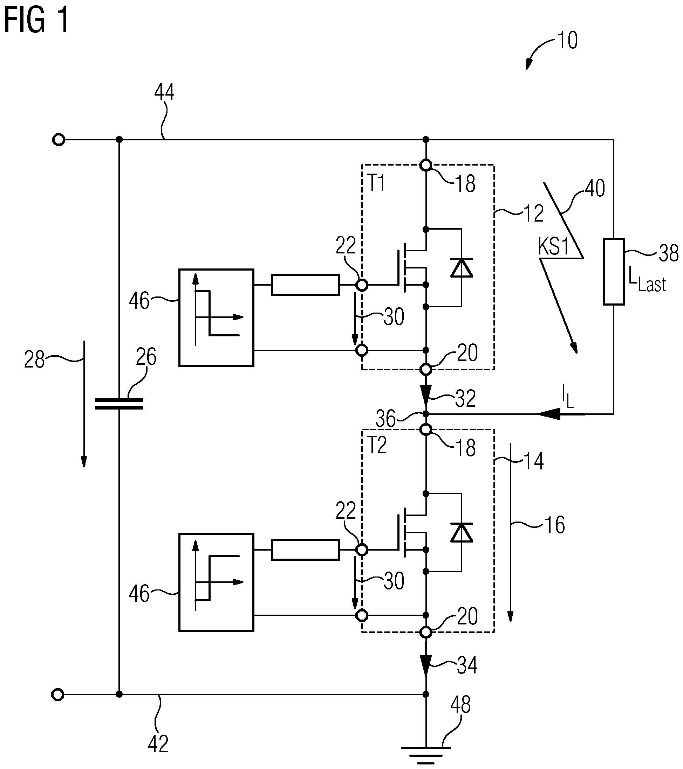

FIG 1 zeigt in einer schematischen Schaltbildanordnung eine Halbbrückenschaltung 10, wie sie in Energiewandlern, beispielsweise Wechselrichtern, Umrichtern, Gleichspannungswandlern oder dergleichen zum Einsatz kommt. Die Halbbrückenschaltung 10 umfasst eine Reihenschaltung aus zwei Feldeffekttransistoren, die hier als MOSFETs 12, 14 ausgebildet sind, wobei die Reihenschaltung aus den MOSFETs 12, 14 an elektrische Potentiale 42, 44 eines nicht weiter bezeichneten Gleichspannungszwischenkreises angeschlossen ist.

Der Gleichspannungszwischenkreis weist einen Zwischenkreiskondensator 26 auf, der an die elektrischen Potentiale 42, 44 angeschlossen ist. Zwischen den elektrischen Potentialen 42, 44 ist eine Zwischenkreisgleichspannung 28 bereitgestellt.

Jeder der MOSFETs 12, 14 weist einen jeweiligen Drain-Anschluss 18, einen jeweiligen Source-Anschluss 20 sowie einen jeweiligen Gate-Anschluss 22 auf. Die MOSFETs 12, 14 sind vorliegend als Anreicherungstyp ausgebildet und umfassen ferner jeweils eine integrierte Inversdiode, die nicht weiter bezeichnet ist.

Für jeden der beiden MOSFETs 12, 14 ist eine jeweilige Treiberschaltung 46 vorgesehen, die mit einem Bezugspotentialanschluss an den jeweiligen Source-Anschluss 20 und über einen nicht weiter bezeichneten elektrischen Widerstand an den jeweiligen Gate-Anschluss 22 des jeweiligen MOSFETs 12, 14 angeschlossen ist. Die Treiberschaltungen 46 dienen zum Steuern der MOSFETs 12, 14 in einem Schaltbetrieb, sodass die MOSFETs 12, 14 wechselweise eingeschalter bzw. ausgeschaltet werden. Zu diesem Zweck erhalten die Treiberschaltungen 46 entsprechende Steuersignale von einem nicht weiter dargestellten Taktgeber. Die Steuersignale sind vorliegend geeignete Rechtecksignale, die ein vorgegebenes Taktmuster repräsentieren, damit die Halbbrückenschaltung 10 die gewünschte Funktionalität bereitstellt.

Mittels der Treiberschaltungen 46 werden die MOSFETs 12, 14 im Schaltbetrieb betrieben, das heißt, im bestimmungsgemäßen Betrieb nimmt eine Schaltstrecke zwischen dem jeweiligen Drain-Anschluss 18 und dem jeweiligen Source-Anschluss 20 entweder nur einen eingeschalteten Schaltzustand oder einen ausgeschalteten Schaltzustand ein. Die Steuerschaltungen 46 stellen hierfür entsprechende Gate-Steuersignale 30 an den jeweiligen Gate-Anschlüssen 22 bereit, die üblicherweise im Wesentlichen durch Rechtecksignale gebildet sind, sodass die MOSFETs 12, 14 die jeweils gewünschten der Schaltzustände einnehmen.

Dabei ist in der Regel vorgesehen, dass jeweils immer nur einer der beiden MOSFETs 12, 14 in einem eingeschalteten Schaltzustand ist, wohingegen im gleichen Zeitraum der entsprechende andere der beiden MOSFETs 12, 14 im jeweils ausgeschalteten Schaltzustand ist. Dadurch wird ein Kurzschlussstrom, der durch beide MOSFETs 12, 14 gleichzeitig strömt, im Wesentlichen vermieden.

Die Reihenschaltung der MOSFETs 12, 14 wird dadurch gebildet, dass der Source-Anschluss 20 des MOSFET 12 elektrisch unmittelbar an den Drain-Anschluss 18 des MOSFET 14 angeschlossen ist. Hierdurch wird ein Mittelanschluss 36 der Reihenschaltung gebildet.

An dem Mittelanschluss 36 ist als schematische Last 38 eine Induktivität mit einem ersten Anschluss angeschlossen, wobei ein zweiter Anschluss der Last 38 an das positive elektrische Potential 44 angeschlossen ist, welches vorliegend das positive Potential der Zwischenkreisgleichspannung 28 darstellt. Das negative elektrische Potential 42 ist vorliegend mit einem Erdungsanschluss 48 elektrisch gekoppelt. Diese Anschlüsse der Last 38 sind hier lediglich schematisch und können je nach Funktionalität und/oder Art der Last 38 natürlich auch anders gewählt sein oder teilweise auch entfallen.

Aus FIG 1 ist ferner ersichtlich, dass an den jeweiligen MOSFETs 12, 14 eine jeweilige Drain-Source-Spannung 16 ($U_{DS}$) abfällt. In FIG 1 ist lediglich exemplarisch die Drain-Source-Spannung 16 des MOSFET 14 dargestellt. In gleicher Weise ist jedoch auch am MOSFET 12 eine entsprechende Drain-Source-Spannung feststellbar.

Im eingeschalteten Schaltzustand kann die Drain-Source-Spannung 16 ($U_{DS}$) erfasst werden, um für den jeweiligen der MOSFETs 12, 14 zu ermitteln, ob dieser mit einem Überlaststrom beansprucht wird. Zu diesem Zweck kann die Drain-Source-Spannung 16 ($U_{DS}$) mit einem vorgegebenen Spannungsvergleichswert verglichen werden.

Feldeffekttransistoren, insbesondere die MOSFETs 12, 14, stellen als unipolare Halbleiterbauteile im eingeschalteten Schaltzustand eine Schaltstrecke bereit, die eine widerstandsähnliche Charakteristik aufweist. Dadurch kann der Spannungsvergleichswert gegenüber einer Anwendung bei bipolaren Transistoren wie z.B. Insulated Gate Bipolar Transistor (IGBT) deutlich reduziert sein. Vorzugsweise kann der Spannungsvergleichswert an einem Spannungsabfall an der Schaltstrecke bemessen werden, der etwa einer Drain-Source-Spannung entspricht, die bei einem dreifachen Bemessungsstrom des MOSFET 12, 14 anliegt.

Da die Drain-Source-Spannung zumindest bei einer derartigen Belastung von einer Temperatur des MOSFET, insbesondere einer Chip-Temperatur eines Halbleiter-Chips des MOSFET 12, 14 abhängt, ist vorliegend auch vorgesehen, dass der Spannungsvergleichswert abhängig von einer mittels eines nicht weiter dargestellten Temperatursensors erfassten Chip-Temperatur eingestellt wird.

Da für eine Kurzschlussdetektion die Drain-Source-Spannung 16 im eingeschalteten Schaltzustand als temperatursensitiver Parameter ausgewertet wird, wird bei einem fest eingestellten Spannungsvergleichswert der entsprechende Stromwert, ab dem dies als Überlaststrom detektiert wird, abhängig von der Temperatur des MOSFET 12, 14, insbesondere seiner Chip-Temperatur variieren. Dabei kann die folgende Formel relevant sein:

$$I_{SCD}/I_N \sim 1/I_{Rds,on}$$

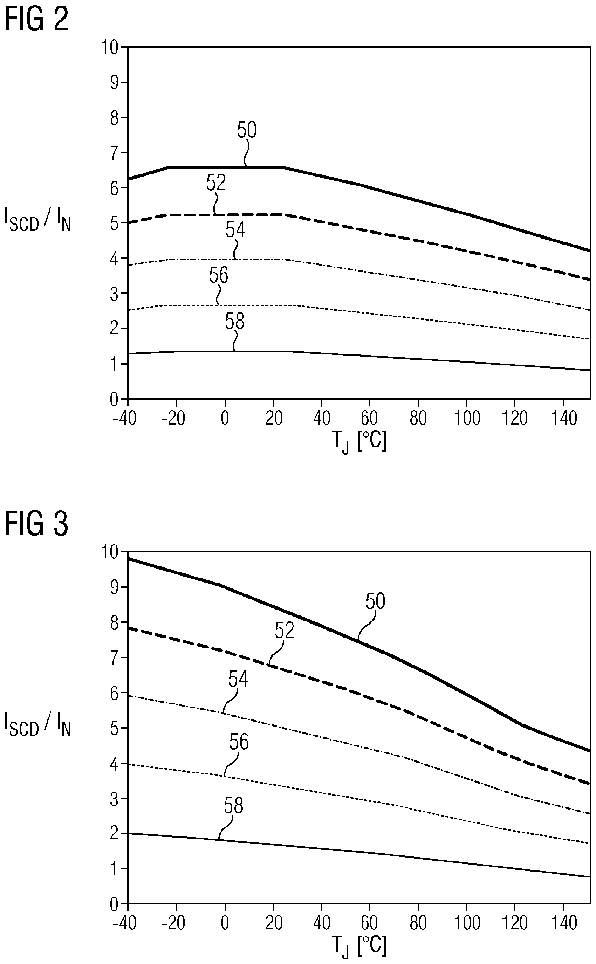

Aufgrund der hohen Temperaturabhängigkeit des Einschaltwiderstands der Schaltstrecke der MOSFETs 12, 14, insbesondere wenn sie als planare bzw. trench SiC MOSFET ausgebildet sind, kann im bestimmungsgemäßen Betrieb beispielsweise eine Abweichung um einen Faktor 2 auftreten, wie aus den schematischen Diagrammdarstellungen der FIG 2 und 3 ersichtlich ist.

FIG 2 zeigt eine schematische Diagrammdarstellung, bei der die Abszisse einer Chip-Temperatur $T_J$ in °C zugeordnet ist, und die Ordinate einem Stromverhältnis $I_{SCD}$, welches einem Überlaststrom in Bezug auf einen Bemessungsstrom $I_N$ entspricht. Die in dem Diagramm der FIG 2 dargestellten Graphen 50, 52, 54, 56, 58 beziehen sich auf unterschiedliche Belastungen. So ist der Graph 50 einem Produkt aus dem fünffachen Bemessungsstrom und einem Einschaltwiderstand des MOSFET 12, 14 zugeordnet ($5*I_N*R_{DS.on}$). Der Graph 52 ist entsprechend dem vierfachen Produkt aus dem Bemessungsstrom und dem Einschaltwiderstand zugeordnet. Entsprechend ist der Graph 54 dem dreifachen Produkt, der Graph 56 dem zweifachen Produkt und der Graph 58 dem einfachen Produkt zugeordnet. Für diese Diagrammdarstellung wird eine Gate-Source-Spannung 30 von etwa 15 V bereitgestellt.

FIG 3 zeigt eine entsprechende Diagrammdarstellung wie FIG 2, bei der jedoch die Gate-Source-Spannung 30 etwa 20 V beträgt. Bei Silizium-MOSFETs kann eine Kompensation derart vorgesehen sein, dass ein Spannungsteiler, mittels dem der Spannungsvergleichswert bereitgestellt wird, einen temperaturabhängigen Widerstand umfasst, der als Temperatursensor dient, um die Chip-Temperatur des jeweiligen MOSFET 12, 14 zu erfassen.

Die erfasste Drain-Source-Spannung 16 kann mit dem Spannungsvergleichswert verglichen werden, indem z.B. ein entsprechender Komparator bzw. eine Komparatorschaltung oder auch eine digitale Verarbeitung mittels einer Rechnereinheit vorgesehen wird. Darüber hinaus kann auch eine Ausblendzeit vorgesehen werden, die mittels eines analogen RC-Gliedes realisiert sein kann.

Auch wenn sich die Erfindung insgesamt bei Feldeffekttransistoren, insbesondere MOSFETs, einsetzen lässt, erweist sie sich jedoch als besonders vorteilhaft für den Einsatz bei Halbleitern mit breitem Bandabstand, englisch auch Wide-Bandgap Semiconductor genannt. Halbleiter mit breitem Bandabstand sind Halbleiter, deren Bandabstand bzw. Bandlücke, das heißt, ein Energieabstand zwischen einem Valenzband und einem Leitungsband, am oberen Ende des Bereichs der Halbleiter liegt, z.B. größer als etwa 3 eV bis über etwa 4 eV oder dergleichen.

Die Eigenschaften von Halbleiterwerkstoffen werden überwiegend durch den Bandabstand bestimmt. Bei elektrischen Leitern besteht keine Bandlücke, während die Bandlücke bei Nichtleitern in der Regel größer als etwa 4 eV ist. Bei einer Vielzahl von bislang üblichen Halbleitern liegt der Bandabstand in einem Bereich deutlich kleiner als etwa 3 eV, so z.B. bei Raumtemperatur für Germanium etwa 0,67 eV, für Silizium bei etwa 1,12 eV, für Galliumarsenid etwa 1,42 eV und so weiter.

Bei Halbleitern mit breitem Bandabstand ist der Bandabstand in der Regel größer als etwa 3 eV. Die Verwendung von Halbleitern mit breitem Bandabstand, insbesondere für Transistoren, besonders für Feldeffekttransistoren, kann geringere Schaltverluste bei einem Schaltbetrieb zur Folge haben. Darüber hinaus kann eine Spannungsfestigkeit in einem ausgeschalteten Schaltzustand höher sein. Schließlich eignen sich derartige Halbleiter auch für den Einsatz bei hohen Temperaturen. Es können ferner höhere Frequenzen für den bestimmungsgemäßen Betrieb genutzt werden und die Zuverlässigkeit kann verbessert sein. Werkstoffe, die Halbleiter mit breitem Bandabstand sind, sind z.B. Siliziumcarbid, Galliumnitrid, Zinkoxid und/oder dergleichen.

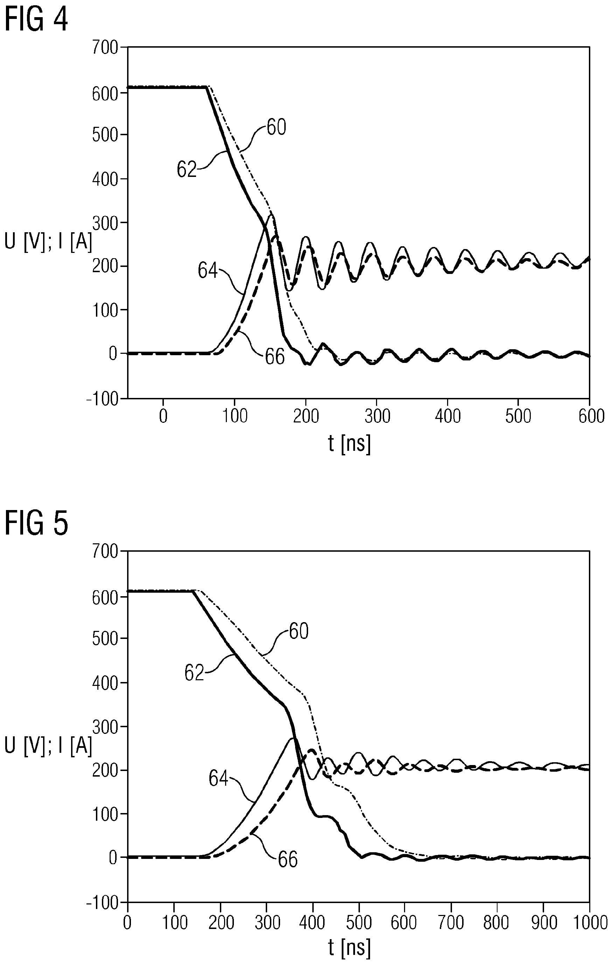

FIG 4 zeigt in einer schematischen Diagrammdarstellung ein Einschaltverhalten eines SiC MOSFET, wie dem MOSFET 12, 14, bei verschiedenen Chip-Temperaturen $T_J$ und einer Kommutierungsinduktivität $L_\sigma$ von etwa 20 nH. Die Betriebsspannung beträgt hier etwa 600 V. Im eingeschalteten Schaltzustand stellt sich ein Drain-Strom von etwa 200 A ein. $R_{G,ext}$ beträgt vorliegend 17,2 Ω.

In dem in FIG 4 dargestellten Diagramm ist die Abszisse der Zeit in ns zugeordnet. Dagegen ist die Ordinate sowohl der Spannung in V sowie auch dem Strom in A zugeordnet. Mit einem Graphen 60 ist die Drain-Source-Spannung 16 bei einem Einschaltvorgang des MOSFET 12 dargestellt. Vorliegend liegt die Chip-Temperatur bei etwa 25°C. Mit einem Graphen 62 ist die gleiche Spannung dargestellt, wobei hier jedoch die Chip-Temperatur 150°C beträgt. Entsprechend zugeordnet sind Graphen 64 und 66, die einen entsprechenden Drain-Strom beim Einschalten des MOSFET 14 zeigen. Der Graph 64 ist dabei der Chip-Temperatur 25°C zugeordnet, wobei der Graph 66 der Chip-Temperatur 150°C zugeordnet ist. Zu erkennen ist, dass während des Einschaltvorgangs eine Stromschwingung angeregt wird, die mit zunehmender Zeit abklingt.

FIG 5 zeigt eine entsprechende schematische Diagrammdarstellung wie FIG 4, wobei hier jedoch die Induktivität $L_\sigma$ etwa 125 nH beträgt. Zu erkennen ist, dass die Steilheit des Spannungsabfalls gemäß der Graphen 60, 62 hier kleiner ist als im Betriebsfall gemäß FIG 4. Ebenso wird eine kleinere Schwingung im Drain-Strom angeregt, die darüber hinaus auch schneller abklingt. Bei der größeren Temperatur ist eine Amplitude der angeregten Schwingung ebenfalls größer.

Aus den FIG 4 und 5 ergibt sich, dass der Vergleichsspannungswert z.B. zumindest teilweise unter Berücksichtigung des Abklingverhaltens der Stromschwingung eingestellt werden kann. Dadurch kann die Überlaststromerkennung deutlich verbessert werden. So kann z.B. eine temperaturabhängig einstellbare Ausblendzeit vorgesehen sein, die zwischen den in den FIG 4 und 5 dargestellten Schaltzuständen um etwa 100 ns variiert werden kann. Dies ermöglicht es, z.B. bei einer Stromanstiegsgeschwindigkeit von etwa 3 Ampere pro Sekunde die Erkennung eines Überlaststromwertes um etwa 300 A zu reduzieren. Dadurch kann die Detektion des Überlaststroms deutlich verbessert werden.

Die Erfindung nutzt also die Tatsache, dass der Spannungsvergleichswert nicht nur von der Temperatur des Feldeffekttransistors, insbesondere dessen Chip-Temperatur abhängig sein kann, sondern zusätzlich eine temperaturabhängige Zeitabhängigkeit des Spannungsvergleichswerts vorgesehen sein kann. Die Erfindung ermöglicht also eine zweidimensionale Nachführung der Detektion eines Überlaststromes.

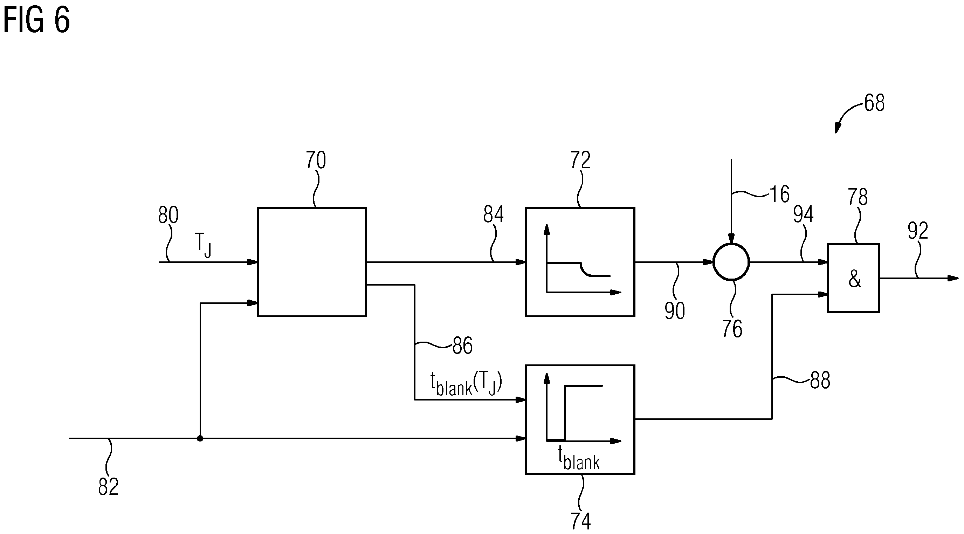

Eine schematische Blockschaltbilddarstellung für eine Schaltungsanordnung, mit der die Erfindung realisiert werden kann, zeigt FIG 6. FIG 6 zeigt eine schematische Blockschaltbildanordnung 68, die eine digitale Signalverarbeitung mit einer Schaltungsanordnung 70 umfasst. Die Schaltungsanordnung 70 ist vorliegend durch einen Field Programmable Gate Array (FPGA) gebildet. Alternativ oder ergänzend hierzu kann auch eine Rechnereinheit vorgesehen sein, die mittels eines geeigneten Rechnerprogramms entsprechend gesteuert wird. Als Eingangsgröße wird der Schaltungsanordnung 70 ein Temperatursignal 80 von einem nicht weiter dargestellten Temperatursensor bereitgestellt, der eine Chip-Temperatur des jeweiligen MOSFET 12, 14 erfasst.

Darüber hinaus erhält die Schaltungsanordnung 70 als Eingangssignal 82 ein Steuersignal, welches auch dazu dient, den MOSFET 12, 14 in geeigneter Weise im Schaltbetrieb zu betreiben. Als Ausgangssignale liefert die Schaltungsanordnung 70 ein digitales Signal 84, welches dazu dient, eine digitale Spannungsquelle 72 entsprechend zu steuern. Die digitale Spannungsquelle 72 stellt als Spannungsvergleichswert 90 ein Referenzsignal bereit. Der Spannungsvergleichswert 90 wird einem Vergleicher 76 zugeführt, dem ebenfalls die Drain-Source-Spannung 16 zugeführt wird. Der Vergleicher 76 vergleicht die beiden Signale 16, 90 und liefert ein digitales Vergleichssignal als Ausgangssignal 94, welches einem UND-Gatter 78 zugeführt wird.

Parallel hierzu wird ein digitales Steuersignal 86 von der Schaltungsanordnung 70 bereitgestellt, welches zum Einstellen eines ersten Zeitpunkts dient. Dieses Signal wird einer einstellbaren Zeitverzögerungsschaltung 74 zugeführt, die als Ausgangssignal ein Steuersignal 88 liefert, welches dem UND-Gatter 78 ebenfalls als Eingangssignal zugeführt wird. Zugleich wird der Zeitverzögerungsschaltung 74 auch das Eingangssignal 82 als Eingangssignal zugeführt. Das UND-Gatter 78 liefert ein Ausgangssignal 92 (SCDS), welches dazu dient, einen Überlaststrom anzuzeigen. Dieses Signal dient dann im weiteren Verlauf dazu, den jeweiligen MOSFET 12, 14 entsprechend auszuschalten.

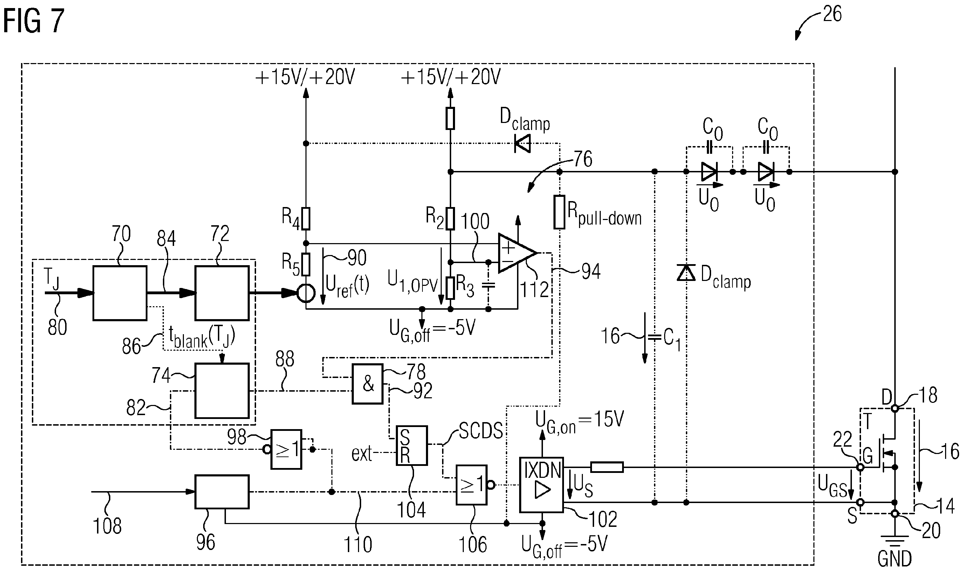

Vorliegend ist vorgesehen, dass sich über die Schaltungsanordnung 70 der Spannungsvergleichswert 90 mittels der einstellbaren Spannungsquelle 72 in 256 Stufen einstellen lässt. Zu diesem Zweck weist die Spannungsquelle 72 einen 8-Bit-Eingang auf. Damit lässt sich nicht nur ein konstanter Wert einstellen, sondern auch ein zeitabhängiger Spannungsvergleichswert, wie anhand der folgenden Darstellung gemäß FIG 7 ersichtlich ist.

FIG 7 zeigt eine schematische Schaltbilddarstellung für eine Treiberschaltung 46 für den MOSFET 14. Für den MOSFET 12 kann eine entsprechende Schaltung gleichermaßen vorgesehen sein.

Die Schaltungsanordnung 46 umfasst einen Eingang, an dem ein Steuersignal 108 für den bestimmungsgemäßen Betrieb des MOSFETs 14 vom Taktgeber zugeführt wird. Das Steuersignal 108 wird einem Optokoppler 96 zugeführt, der dazu dient, das Steuersignal 108 galvanisch vom Potential des MOSFET 14 zu trennen. Der Optokoppler 96 liefert als Ergebnis ein potentialfreies Steuersignal 110, welches hinsichtlich seiner zeitlichen Eigenschaften dem Steuersignal 108 entspricht.

Das Steuersignal 110 wird über ein NOR-Gatter 98 der Zeitverzögerungsschaltung 74 als Eingangssignal 82 zugeführt. Bezüglich der weiteren Funktionen bis zum UND-Gatter 78 wird auf die Ausführungen zur FIG 6 verwiesen. Anzumerken ist, dass das Ausgangssignal 92 einem S-Eingang eines RS-Flipflops 104 zugeführt wird, welches entsprechend ein Ausgangssignal auf ein NOR-Gatter 106 abgibt. Dem NOR-Gatter 106 wird ferner das Steuersignal 110 als Eingangssignal zugeführt. Das NOR-Gatter 106 liefert als Ausgangssignal ein Steuersignal für eine Gate-Treiberschaltung 102, die den MOSFET 14 an seinem Gate-Anschluss 22 entsprechend ansteuert.

Der Vergleicher 76 ist in FIG 7 detaillierter dargestellt. Er weist einen Komparator 112 auf, an dessen nicht invertierenden Eingang der Spannungsvergleichswert 90 bereitgestellt wird. Am invertierenden Eingang wird eine aus der Drain-Source-Spannung 16 abgeleitete Vergleichsspannung 100 zugeführt. Der Komparator 112 liefert das Ausgangssignal 94 wie zuvor bereits erläutert.

Die Schaltungsanordnung 68 der Erfindung erlaubt es auch, die Ausblendzeit, und zwar den ersten Zeitpunkt, mittels der Schaltungsanordnung 70 der digitalen Zeitverzögerungsschaltung 74 abhängig von der Temperatur nachzuführen. Dadurch ergibt sich ein Schutzbereich für den jeweiligen MOSFET 12, 14, der zweidimensional temperaturkompensiert werden kann. Überschreitet die Drain-Source-Spannung 16 im eingeschalteten Schaltzustand den Spannungsvergleichswert 90, springt das Ausgangssignal 94 auf "high" und sobald die abgelaufene Zeit t größer als der erste Zeitpunkt ist, wird dies als Überlaststromereignis detektiert. Dabei wird das entsprechende Signal, Short Circuit Detection Signal (SCDS), dem RS-Flipflop 104 zugeführt, wodurch dies gesetzt wird. Sobald dieses Signal anliegt, wird die Gate-Treiberschaltung 102 für den MOSFET 14 bzw. 12 deaktiviert, obwohl weiterhin das Steuersignal 110 den eingeschalteten Schaltzustand fordert.

Die Treiberschaltung 46 kann natürlich auch einen anderen strukturellen Aufbau aufweisen, um die gewünschte Funktionalität gemäß der Erfindung zu realisieren. Insofern ist die Beschreibung lediglich der Erläuterung anhand eines Ausführungsbeispiels zu verstehen und nicht, um den Gegenstand der Erfindung zu beschränken.

Der Spannungsvergleichswert 90 kann dabei auf folgende Arten nachgeführt werden: In einem ersten Zeitraum zwischen einem Beginn des eingeschalteten Schaltzustands bis zum ersten Zeitpunkt $t_1$ kann vorgesehen sein, dass der Spannungsvergleichswert zur schnellen Detektion von Kurzschlüssen des ersten Falls auf einen Maximalwert eingestellt wird. In einem Zeitraum, der größer ist als ein zweiter Zeitpunkt $t_2$, wobei der zweite Zeitpunkt $t_2$ später als der erste Zeitpunkt $t_1$ liegt, kann der Spannungsvergleichswert 90 zur schnelleren Detektion von Kurzschlüssen des zweiten und des dritten Falls und zur Detektion des Überstromfalls auf einen niedrigeren Wert gebracht werden. Für einen Übergangszeitraum zwischen dem ersten Zeitpunkt $t_1$ und dem zweiten Zeitpunkt $t_2$ kann der Spannungsvergleichswert 90 von dem festen Maximalwert auf den Wert zum Zeitpunkt $t_2$ überführt werden. Hierfür können z.B. zwei unterschiedliche Methoden vorgesehen sein.

So ist es möglich, den Übergang linear auszuführen, wodurch natürlich auch eine einfache Programmierbarkeit des Übergangs erreicht werden kann. Eine Programmierung kann z.B. unter Berücksichtigung der folgenden Formel erfolgen:

$$U_{ref,1-on} = U_{ref,1} - ((U_{ref,1-}U_{ref,on})/(t_{2-}t_1)).t$$

Darüber hinaus gibt es die Möglichkeit, einen exponentiellen Übergang zu realisieren. Dies kann z.B. unter Nutzung der folgenden Formel erfolgen:

$$U_{ref,1-on} = (U_{ref,1-}U_{ref,on}).(1-e^{\wedge}((t-t_1)/\tau) + U_{ref\,1}$$

Dabei kann die Zeitkonstante $\tau$ der e-Funktion passend zur Abklingkonstante gewählt werden, wie es z.B. anhand von den FIG 4 und 5 erläutert wurde.

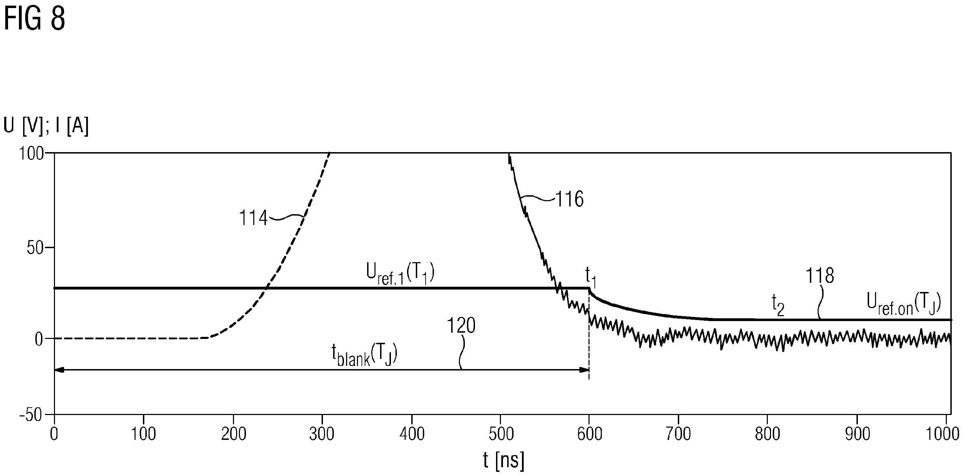

FIG 8 zeigt ein schematisches Diagramm, welches den Schutzbereich zur Überlaststromdetektion in Bezug auf die entsprechenden Fälle 1 bis 3 darstellt. Die Abszisse ist hier wieder der Zeit in ns und die Ordinate der elektrischen Spannung in V bzw. dem elektrischen Strom in A zugeordnet. Die Betriebsspannung beträgt vorliegend etwa 600 V. Die Induktivität $L_\sigma$ beträgt etwa 125 nH. Der Drain-Strom liegt bei etwa 200 A und der elektrische Widerstand $R_{G,ext}$ beträgt etwa 17,2 Ω.

In FIG 8 zeigt ein Graph 114 den Stromverlauf des Drain-Stroms, wohingegen ein Graph 116 den Spannungsverlauf der Drain-Source-Spannung 16 darstellt. Mit einem Graphen 118 ist der Spannungsverlauf des Spannungsvergleichswerts 90 dargestellt. Der Graph 120 stellt die Ausblendzeit dar, die durch den Zeitpunkt $t_1$ als erster Zeitpunkt begrenzt ist.

Die Erfindung lässt sich sowohl durch eine analoge Hardwareschaltung als auch durch eine digitale Schaltung oder auch mittels einer Rechnereinheit realisieren. Natürlich können diese Möglichkeiten der Realisierung auch miteinander in geeigneter Weise kombiniert sein.

Mit der Erfindung ist es möglich, eine bereits bestehende, analoge Lösungsvariante der Temperaturnachführung des Spannungsvergleichswerts 90 unter Nutzung eines temperaturabhängigen Widerstands über eine beispielsweise digitale Spannungsquelle digital zu realisieren. Gleichzeitig kann auch eine Einstellung der Ausblendzeit bzw. des ersten Zeitpunktes $t_1$ digital realisiert sein. Dadurch kann eine zweidimensionale Nachführung realisiert werden. Dies erlaubt es, einen Schutzbereich vom Anwender individuell zu definieren und zugleich eine entsprechende Temperaturkompensation vorzusehen.

Es ist also bei der Erfindung nicht nötig, eine getrennte Auswertung mittels getrennter Detektionspfade für den Spannungsvergleichswert und die Ausblendzeit vorzusehen. Die Erfindung erlaubt es, z.B. zwei getrennte Spannungsvergleichswerte vorzusehen und diese mittels getrennter Ausblendzeiten zu realisieren. So ist es möglich, einen großen Spannungsvergleichswert mit einer kurzen Ausblendzeit zur Detektion von Überlaststromereignissen des Falls 1 und einen kleineren Spannungsvergleichswert zu realisieren, welcher temperaturkompensiert digital zur Detektion von Überlaststromereignissen der Fälle 2 und 3 sowie einem Überstrom nach einer weiteren Ausblendzeit ermöglicht.

Die Ausführungsbeispiele dienen ausschließlich der Erläuterung der Erfindung und sollen diese nicht beschränken.

**Patentansprüche**

1.  Verfahren zum Schutz eines in einem Schaltbetrieb betriebenen Feldeffekttransistors (12,14) vor einem Überlaststrom in einem eingeschalteten Schaltzustand, bei dem:

    - eine elektrische Drain-Source-Spannung (16) zwischen einem Drain-Anschluss (18) und einem Source-Anschluss (20) des Feldeffekttransistors (12,14) erfasst wird,
    - die Drain-Source-Spannung (16) miL einem vorgegebenen Spannungsvergleichswert (90) verglichen wird, und
    - der Feldeffekttransistor (12,14) bei einer größeren Drain-Source-Spannung (16) als dem Spannungsvergleichswert (90) in einen ausgeschalteten Schaltzustand geschaltet wird, wobei zum Zwecke einer Temperaturkompensation des Schutzes
    - eine Temperatur des Feldeffekttransistors (12,14) erfasst wird, und
    - der Spannungsvergleichswert (90) während des eingeschalteten Schaltzustands ergänzend auch von der Zeit während des eingeschalteten Schaltzustands abhängt,

    wobei der Spannungsvergleichswert (90) abhängig von der Temperatur eingestellt wird, wobei der Spannungsvergleichswert (90) abhängig von der Zeit während des eingeschalteten Schaltzustands reduziert wird, indem der Spannungsvergleichswert (90) zu einem vorgegebenen ersten Zeitpunkt während des eingeschalteten Schaltzustands um einen vorgegebenen Spannungsreduktionswert reduziert wird, wobei der Spannungsreduktionswert exponentiell geändert wird, wobei eine Zeitkonstante der exponentiellen Änderung des Spannungsreduktionswertes angepasst an eine Abklingzeitkonstante einer Schwingung der Drain-Source-Spannung (16) gewählt wird, wobei der Spannungsvergleichswert (90) zwischen einem Einschaltzeitpunkt des Feldeffekttransistors (12,14) und dem ersten Zeitpunkt ($t_1$) unabhängig von der Temperatur konstant eingestellt wird, wobei der Spannungsreduktionswert zu einem zweiten Zeitpunkt ($t_2$), der später als der erste Zeitpunkt ($t_1$) während des eingeschalteten Schaltzustands liegt, von der Temperatur abhängt und aktiviert wird.

2.  Verfahren nach Anspruch 1, **dadurch gekenn- zeichnet**, dass der erste Zeitpunkt ebenfalls von der Temperatur abhängt.

3.  Verfahren nach Anspruch 2, **dadurch gekenn- zeichnet**, dass der erste Zeitpunkt mit zunehmender Temperatur früher liegt.

4.  Verfahren nach einem der Ansprüche 1 bis 3, **dadurch gekennzeichnet, dass** der Spannungsreduktionswert zu einem dritten Zeitpunkt, der später als der zweite Zeitpunkt ($t_2$) während des eingeschalteten Schaltzustands liegt, größer ist.

5.  Verfahren nach einem der Ansprüche 1 bis 4, **dadurch gekennzeichnet, dass** der Spannungsvergleichswert (90) zwischen dem ersten und dem zweiten Zeitpunkt ($t_1,t_2$) abhängig von der Zeit kontinuierlich geändert wird.

6.  Schutzeinrichtung (24) für einen in einem Schaltbetrieb betriebenen Feldeffekttransistor (12,14) zum Schutz vor einem Überlaststrom in einem eingeschalteten Schaltzustand, zu welchem Zweck die Schutzeinrichtung (24) ausgebildet ist,

    - eine elektrische Drain-Source-Spannung (16) zwischen einem Drain-Anschluss (18) und einem Source-Anschluss (20) des Feldeffekttransistors (12,14) zu erfassen,
    - die Drain-Source-Spannung (16) mit einem vorgegebenen Spannungsvergleichswert (90) zu vergleichen, und

- den Feldeffekttransistor (12,14) bei einer größeren Drain-Source-Spannung (16) als dem Spannungsvergleichswert (90) in einen ausgeschalteten Schaltzustand zu schalten,
und zum Zwecke einer Temperaturkompensation des Schutzes
- eine Temperatur des Feldeffekttransistors (12,14) zu erfassen, und
- den Spannungsvergleichswert (90) während des eingeschalteten Schaltzustands ergänzend auch abhängig von der Zeit während des eingeschalteten Schaltzustands einzustellen,

**dadurch gekennzeichnet, dass** die Schutzeinrichtung (24) ferner zur Durchführung des Verfahrens nach einem der Ansprüche 1 bis 5 ausgebildet ist.

7. Feldeffekttransistor (12,14) mit einer Schutzeinrichtung (24) nach Anspruch 6.

8. Energiewandler, insbesondere ein Umrichter, ein Wechselrichter oder ein Gleichspannungswandler mit einem Feldeffekttransistor nach Anspruch 7.


**Claims**

1. Method for protecting a field-effect transistor (12,14) operated in a switching mode against an overload current in a turned-on switching state, in which:

   - an electrical drain-source voltage (16) is detected between a drain terminal (18) and a source terminal (20) of the field-effect transistor (12,14),
   - the drain-source voltage (16) is compared with a predefined voltage comparison value (90), and
   - the field-effect transistor (12,14) is switched into a turned-off switching state if the drain-source voltage (16) is greater than the voltage comparison value (90),
   wherein, for the purpose of a temperature compensation of the protection,
   - a temperature of the field-effect transistor (12,14) is measured, and
   - during the turned-on switching state, the voltage comparison value (90) is additionally also dependent on the time during the turned-on switching state,

   wherein the voltage comparison value (90) is set as a function of the temperature, wherein the voltage comparison value (90) is reduced as a function of the time during the turned-on switching state, wherein the voltage comparison value (90) is reduced by a predefined voltage reduction value at a predefined first time point during the turned-on switching state, wherein the voltage reduction value is varied exponentially, wherein a time constant of the exponential variation of the voltage reduction value is chosen adjusted to a decay time constant of an oscillation of the drain-source voltage (16), wherein the voltage comparison value (90) is set to a constant value between a turn-on time point of the field-effect transistor (12,14) and the first time point $(t_1)$ independently of the temperature, wherein the voltage reduction value is dependent on the temperature and is activated at a second time point $(t_2)$ that lies later than the first time point $(t_1)$ during the turned-on switching state.

2. Method according to claim 1, **characterised in that** the first time point is likewise dependent on the temperature.

3. Method according to claim 2, **characterised in that** the first time point lies earlier with increasing temperature.

4. Method according to one of claims 1 to 3,
   **characterised in that** the voltage reduction value is greater at a third time point that lies later than the second time point $(t_2)$ during the turned-on switching state.

5. Method according to one of claims 1 to 4,
   **characterised in that** the voltage comparison value (90) is varied continuously as a function of time between the first and the second time point $(t_1, t_2)$.

6. Protective device (24) for a field-effect transistor (12,14) operated in a switching mode for protecting against an overload current in a turned-on switching state, for which purpose the protective device (24) is embodied

   - to detect an electrical drain-source voltage (16) between a drain terminal (18) and a source terminal (20) of the field-effect transistor (12,14),

- to compare the drain-source voltage (16) with a predefined voltage comparison value (90), and
- to switch the field-effect transistor (12,14) into a turned-off switching state if the drain-source voltage (16) is greater than the voltage comparison value (90),
and, for the purpose of a temperature compensation of the protection,
- to measure a temperature of the field-effect transistor (12,14), and
- to set the voltage comparison value (90) during the turned-on switching state additionally also as a function of the time during the turned-on switching state,

**characterised in that**
the protective device (24) is further embodied to perform the method according to one of claims 1 to 5.

7. Field-effect transistor (12,14) having a protective device (24) according to claim 6.

8. Energy converter, in particular an AC-to-AC converter, a DC-to-AC inverter or a DC-to-DC converter having a field-effect transistor according to claim 7.


**Revendications**

1. Procédé de protection d'un transistor (12, 14) à effet de champ, dans un fonctionnement de commutation, vis-à-vis d'un courant de surcharge dans un état de commutation passant, dans lequel :

   - on relève une tension (16) électrique de drain-source entre une borne (18) de drain et une borne (20) de source du transistor (12, 14) à effet de champ,
   - on compare la tension (16) de drain-source à une valeur (90) de comparaison de tension donnée à l'avance, et
   - on met le transistor (12, 14) à effet de champ dans un état de commutation bloqué, si la tension (16) de drain-source est plus haute que la valeur (90) de comparaison de tension,
   dans lequel, aux fins d'une compensation de température de la protection
   - on détecte une température du transistor (12, 14) à effet de champ, et
   - la valeur (90) de comparaison de la tension, pendant l'état de commutation passant, dépend également en complément du temps pendant l'état de commutation passant,

   dans lequel on règle la valeur (90) de comparaison de la tension en fonction de la température, dans lequel on réduit la valeur (90) de la comparaison de la tension en fonction du temps, pendant l'état de commutation passant, en réduisant la valeur (90) de comparaison de la tension à un premier instant donné à l'avance pendant l'état de commutation passant d'une valeur de réduction de la tension donnée à l'avance, dans lequel on modifie exponentiellement la valeur de réduction de la tension, dans lequel on choisit une constante de temps de la variation exponentielle de la valeur de réduction de la tension, d'une manière adaptée à une constante d'amortissement d'une oscillation de la tension (16) de drain-source, dans lequel on règle la valeur (90) de comparaison de la tension entre un instant de mise à l'état passant du transistor (12, 14) à effet de champ et le premier instant ($t_1$) à une valeur constante indépendamment de la température, dans lequel la valeur de réduction de la tension à un deuxième instant ($t_2$), qui est postérieur au premier instant ($t_1$) pendant l'état de commutation passant, dépend de la température et est activée.

2. Procédé suivant la revendication 1, **caractérisé en ce que** le premier instant dépend également de la température.

3. Procédé suivant la revendication 2, **caractérisé en ce que** le premier instant est d'autant plus antérieur que la température s'élève.

4. Procédé suivant l'une des revendications 1 à 3, **caractérisé en ce que** la valeur de réduction de la tension à un troisième instant, qui est postérieur au deuxième instant ($t_2$) pendant l'état de commutation passant, est plus grande.

5. Procédé suivant l'une des revendications 1 à 4, **caractérisé en ce que** l'on modifie continuellement en fonction du temps la valeur (90) de comparaison de la tension entre le premier et le deuxième instants ($t_1$, $t_2$).

6. Dispositif (24) de protection d'un transistor (12, 14) à effet de champ en fonctionnement en commutation pour la protection vis-à-vis d'un courant de surcharge vis à vis d'un courant de surcharge, en vue de laquelle le dispositif (24) de protection est constitué pour

- détecter une tension (16) électrique de drain-source entre une borne (18) de drain et une borne (20) de source du transistor (12, 14) à effet de champ,
- comparer la tension (16) de drain-source à une valeur (90) de comparaison de la tension donnée à l'avance, et
- mettre le transistor (12, 14) à effet de champ dans un état de commutation bloqué, si la tension (16) de drain-source est plus haute que la valeur (90) de comparaison de la tension,
et en vue d'une compensation de la température de la protection pour
- détecter une température du transistor (12, 14) à effet de champ, et
- régler la valeur (90) de comparaison de la tension pendant l'état de commutation passant également en complément en fonction du temps pendant l'état de commutation passant,

**caractérisé en ce que**
le dispositif (24) de protection est constitué en outre pour effectuer le procédé suivant l'une des revendications 1 à 5.

7. Transistor (12, 14) à effet de champ ayant un dispositif (24) de protection suivant la revendication 6.

8. Transformateur d'énergie, en particulier convertisseur, onduleur ou transformateur de tension continue comprenant un transistor à effet de champ suivant la revendication 7.

FIG 1

FIG 2

FIG 3

FIG 4

FIG 5

FIG 6

FIG 7

FIG 8

EP 3 711 162 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20170331369 A1
- US 20170163255 A1